# FASCICULE DE BREVET EUROPEEN

(11) **EP 0 267 824 B1**
(45) Date de publication et mention de la délivrance du brevet: **27.01.1993**
(21) Numéro de dépôt: 87402275.9
(22) Date de dépôt: 13.10.1987
(51) Int. Cl.: G02F 1/133, H01L 21/84

(54) **Ecran de visualisation électrooptique à transistors de commande et procédé de réalisation**
Transistor-gesteuerter elektrooptischer Anzeigeschirm und Verfahren zu seiner Herstellung
Transistor-driven electro-optical visualization screen, and method of manufacturing it

(30) Priorité: 17.10.1986 FR 8614410
(43) Date de publication de la demande: 18.05.1988
(73) Titulaire: THOMSON GRAND PUBLIC, 75020 Paris (FR)
(72) Inventeur: Chartier, Eric, F-75008 Paris (FR)
(74) Mandataire: Lepercque, Jean

(56) Documents cités:
- EP-A- 0 103 523
- DE-A- 3 502 911
- PATENT ABSTRACTS OF JAPAN, vol. 10, no. 149 (P-461)[2206], 30 mai 1986; & JP-A-61 3118

## Description

L'invention concerne un écran de visualisation électrooptique à transistors de commande, et plus particulièrement un écran plat dans lequel la commande de chaque élément d'image à visualiser se fait à l'aide d'un transistor. Elle est applicable à la réalisation d'écrans plats à cristal liquide de grande surface dont les transistors de commande se font par intégration sous formes de couches minces. Le procédé selon l'invention permet une réalisation d'un écran par un procédé redondant et un nombre minimal de masques de lithographie.

Comme il est connu, ces écrans comportent généralement un grand nombre de points élémentaires ou éléments d'image de forme carrée ou rectangulaire. Ces éléments d'image doivent être adressés individuellement. La définition de l'écran est fonction du nombre de points susceptibles de recevoir une information. La commande de chaque point se fait par application d'un champ électrique à travers le cristal liquide. Pour la visualisation d'informations alphanumériques ou graphiques, il a été proposé des affichages de type matriciel. Chaque élément d'image est alors défini par l'intersection de deux réseaux de conducteurs orthogonaux appelés lignes et colonnes.

L'adressage de ces écrans matriciels de visualisation revêt une importance de plus en plus considérable au fur et à mesure qu'on cherche à en augmenter la définition, c'est-à-dire le nombre de points élémentaires d'image.

Les points élémentaires étant adressés séquentiellement ligne par ligne, le nombre de lignes pouvant être adressé est en général limité par les caractéristiques de l'effet électrooptique du cristal liquide utilisé. L'écart de tensions réalisable en adressage direct entre un état allumé et un état éteint, par mise en phase ou en opposition de phase des tensions lignes et colonnes, diminue avec le nombre de lignes. La possibilité d'adresser un grand nombre de lignes (<100) se fait alors au détriment des autres caractéristiques de l'écran (diminution du contraste et variation de plus en plus grande du contraste avec l'angle de vue). Pour améliorer les performances de ces écrans, on peut mettre en série avec chaque point image (constituant une capacité) un transistor ou un élément non linéaire. L'ensemble se comporte alors comme un élément mémoire. Une tension est chargée lorsque le transistor est débloqué par une impulsion de ligne. Cette tension se maintient sur l'élément image pendant le reste du temps de trame pendant lequel le transistor est bloquant.

Actuellement, les exigences de la technique en matière d'écran de visualisation portent sur une meilleure définition de l'image. Dans le cas des écrans du type à affichage matriciel, on est alors amené à concevoir des dispositifs comportant un nombre élevé de lignes ou de colonnes d'adressage. Leur nombre peut aller jusqu'à 1024 voire au-delà. Ceci augmente d'autant le nombre de transistors de commande. Pour la fabrication en série, il est nécessaire notamment d'obtenir un rendement élevé, une bonne reproductibilité et une grande stabilité de ces composants. Il est en outre nécessaire d'adapter, et ce également avec une bonne reproductibilité, les caractéristiques électriques du composant à celle de la cellule associée.

Une manière maintenant usuelle de résoudre ce problème et d'améliorer les performances de ces écrans consiste à réaliser cet adressage à l'aide d'une matrice de transistors en couches minces : ceci revient à coupler directement l'effet électrooptique sur un "circuit intégré" géant mais de basse résolution, chargé d'assurer les fonctions d'aiguillage et de mémorisation de l'information.

Cette approche présente des difficultés technologiques certaines, dans la réalisation tant des transistors en couches minces qu'un niveau des conducteurs d'interconnexion ; en particulier, il e impératif que, parmi les très nombreux croisements entre les lignes et les colonnes du réseau d'interconnexion, aucun ne soit défectueux.

En effet, selon une technique usuelle, les transistors sont situés aux points de croisement de conducteurs de lignes et de conducteurs de colonnes isolés entre eux, de telle façon qu'une différence de potentiel appropriée appliquée entre une ligne et une colonne détermine la conduction ou le blocage, du transistor connecté entre cette ligne, cette colonne et l'élément image adjacent.

La présente invention concerne des écrans de visualisation comprenant une couche de matériau électrooptique commandée par une matrice intégrée de transistors. Cette invention décrit le procédé de fabrication d'un tel écran. Les technologies existantes utilisent 2 ou 3 niveaux de masquages avec des transistors à grille dessus, et 4 à 5 niveaux de masquages pour des transistors à grille dessous. Mais de telles technologies telles que décrites dans le document EP-0-103 523 souffrent d'un manque de souplesse quand on veut améliorer l'image par une capacité de stockage ou un écran de lumière.

Le procédé suivant permet de construire un écran très sophistiqué (écran de lumière et capacité de stockage) en 6 niveaux de masquages, mais cumule les avantages technologiques réalisés avec 7 ou 9 niveaux de masquages. Ces avantages sont la redondance sur les lignes et colonnes qui sont doublées pour éviter les coupures, le double isolement à l'intersection des lignes et des colonnes avec pavé de silicium éventuel en renfort. Il n'y a pas de gravure supplémentaire non critique pour dégager les connexions vers l'extérieur des lignes et des colonnes. Les connexions des lignes et des colonnes peuvent être de même nature. On peut isoler le point image en ITO (oxyde d'indium-étain) entre les deux couches d'isolants, ce qui diminue le nombre de points faux par court-circuit avec la ligne ou la colonne. Ou bien, on peut constituer une capacité de stockage entre la ligne précédente et le point image avec une double couche d'isolants pour éviter les court-circuits. Finalement, cette technologie utilise les transistors à grille en-dessous où le vieillissement des transistors est meilleur au niveau du canal comme au niveau des contacts.

L'invention concerne donc un écran de visualisation électrooptique à transistors de commande comportant :
- une première et une deuxième lames parallèles enserrant un matériau électrooptique ;
- la première lame étant munie sur sa face en contact avec le matériau électrooptique d'une matrice d'éléments image arrangés en lignes et colonnes, d'électrodes de commande de lignes à raison d'une électrode associée à chaque ligne (l'éléments image de ladite matrice et disposé parallèlement à chaque ligne d'éléments image, et de transistors de commande à raison d un transistor par élément image couplant celui-ci à ladite électrode de commande de ligne ;
- la deuxième lame étant munie sur sa face en contact avec le matériau électrooptique d'au moins une électrode ;
- chaque transistor comportant :
- une grille disposée sur la face et associée à une électrode de commande de ligne ;
- une première couche en matériau isolant recouvrant l'ensemble de la face, avec les électrodes de commande de la ligne et les grilles ;
- un élément en matériau semiconducteur amorphe chevauchant la grille ;
- une source disposée sur cet élément en matériau semiconducteur amorphe et s'étendant d'un bord de la grille vers un élément image ;
- un drain disposé sur ledit élément en matériau semiconducteur amorphe et s'étendant d'un autre bord de la grille vers une électrode de colonne ;
- une deuxième couche en matériau isolant recouvrant l'ensemble de l'écran ;
- un écran de lumière disposé au-dessus de la grille ;
   caractérisé en ce qu'il comporte également :
- au moins un élément image situé soit entre la première couche en matériau isolant et la deuxième couche en matériau isolant, soit sur la deuxième couche en matériau isolant ;
- ainsi que les éléments suivants disposés sur la deuxième couche en matériau isolant ;
- un premier élément de connexion connectant la source a l'élément image soit en traversant la deuxième couche d'isolant soit par connexion directe ;
- au moins une électrode de commande de colonne ;
- un deuxième élément de connexion traversant la deuxième couche d'isolant et connectant le drain à ladite colonne.

L'invention concerne également un procédé de réalisation d'un écran à cristal liquide, comportant les étapes suivantes :
a) une première étape de réalisation sur une face de ladite première lame d'électrodes de commande de lignes, de grilles connectées à ces électrodes de commande de lignes et de portions d'électrodes de colonnes ne coupant pas les électrodes de lignes ;
b) une deuxième étape de réalisations successives d'une première couche d'isolant, d'une couche d'un matériau semiconducteur amorphe, d'une couche d'un matériau semiconducteur dopé, et éventuellement d'une couche métallique ;
c) une troisième étape de deux gravures, dans la couche de matériau semiconducteur amorphe, d'éléments chevauchant chacune une grille et, dans la couche de matériau semiconducteur dopé et dans la couche métallique d'une source et d'un drain laissant un espace libre au-dessus de la grille et s'étendant, pour la source, vers l'emplacement d'un élément image et pour le drain vers l'emplacement d'une électrode de colonne ;
d) une quatrième étape de réalisation d'une deuxième couche d'isolant de passivation ;
e) une cinquième étape de gravure de cavités de reprises de contacts traversant la deuxième couche d'isolant à l'emplacement des sources et drains et des cavités de reprises de contacts traversant la première et la deuxième couche d'isolant à l'emplacement des électrodes de lignes et de colonnes ;
f) une sixième étape de dépôt d'une couche d'un matériau conducteur ;
g) une septième étape de gravure d'éléments image dans cette couche conductrice ;
h) une huitième étape de dépôt d'une couche métallique ;
i) une neuvième étape de gravure dans cette couche métallique :
   - d'électrodes de commande de colonnes passant par les cavités de reprises de contact leur permettant d'être connectées à des électrodes de colonnes ;
   - de portions d'électrodes de lignes passant par les cavités de reprise de contacts (CX3) leur permettant d'être connectées à des électrodes de commande de lignes (LG) ;
   - d'éléments de connexion connectant d'une part une source à une électrode de colonne et d'autre part un drain à un élément image ;
   - d'écrans de lumière protégeant de toute lumière incidente le matériau semiconducteur amorphe se trouvant au-dessus de la grille ;
k) une dixième étape de finition d'un écran comportant les opérations suivantes :
   - dépôt d'une couche d'ancrage ;
   - mise en place de cales d'épaisseur ;
   - réalisation d'une contre lame avec contre électrode transparente recouverte d'une couche d'ancrage ;
   - mise en place d'un cristal liquide.

Les différents objets et caractéristique de l'invention apparaîtront plus clairement dans la description qui va suivre faite en se reportant aux figures annexées qui représentent :
- la figure 1, une vue en perspective d'un exemple de réalisation d'un écran à cristal liquide selon l'art connu ;
- la figure 2, une vue générale d'un exemple de réalisation de l'écran à cristal liquide selon l'invention ;
- les figures 3 à 12 différentes étapes du procédé de réalisation de l'écran à cristal liquide selon l'invention ;
- les figures 13 à 14, une variante de réalisation de l'écran à cristal liquide selon l'invention ;
- les figures 15 et 16, une autre variante de réalisation de l'écran à cristal liquide selon l'invention.
- les figures 17 à 19, d'autres variantes de réalisation de l'écran à cristal liquide selon l'invention.

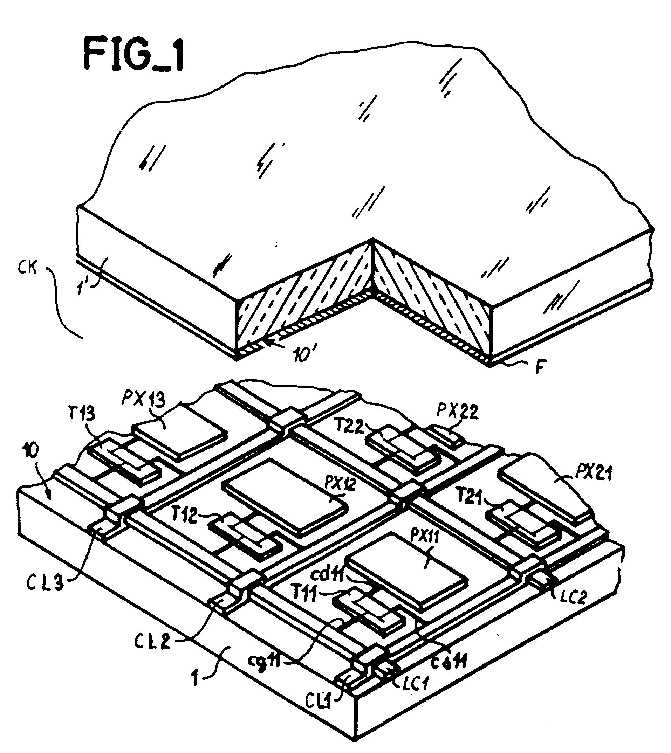

En se reportant à la figure 1, on va tout d'abord décrire un exemple d'écran à cristal liquid e connu dans la technique tel que décrit par exemple dans les demandes de brevets français N^{o} 85.12804 ou 85.16935.

Sur cette figure on trouve sur une face 10 d'une première lame 1 les conducteurs de ligne LG1 et LG2, les conducteurs de colonnes CL1, CL2 et CL3. Connectés sensiblement à chaque point de croisement, on trouve également des transistors et des éléments images tels que le transistor T11 et l'élément image PX11 situés au croisement du conducteur de ligne LG1 et du conducteur de colonne CL1.

Une deuxième lame 1ʹ, de préférence en verre, munie au moins d'une électrode F, détermine avec une de ces faces 10ʹ et la face 10 de la lame 1, un espace dans lequel est placé un cristal liquide CX.

La lame 1ʹ est transparente. Un élément image de la face 10 telle que PX11, la lame 1ʹ en vis-à-vis et le cristal liquide qui les séparent constituent une cellule à cristal liquide de l'écran.

Le fonctionnement d'un tel écran est connu. Rappelons simplement que pour afficher une information sur une cellule de cristal liquide, il faut appliquer à une ligne (LG1 par exemple) et une colonne (CL1 par exemple) des potentiels appropriés rendant conducteur le transistor T11 qui applique alors un potentiel à l'élément image PX11 de telle façon que l'élément image PX11 de la cellule CL11 soit soumise à une différence de potentiel permettant un changement d'état du cristal liquide.

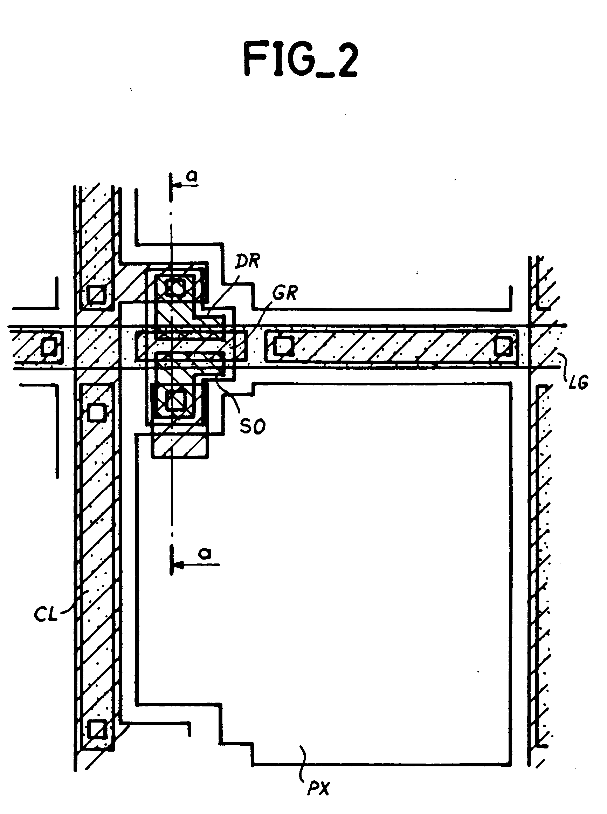

En se reportant aux figures 2, 11 et 12 on va décrire un exemple de réalisation d'un écran de visualisation selon l'invention.

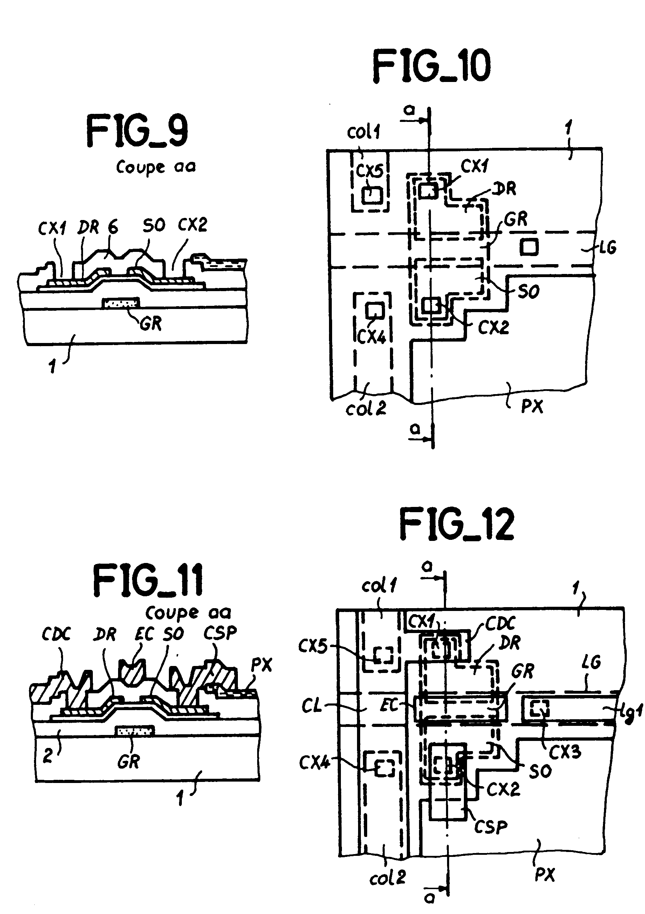

La figure 2 représente une vue générale d'une partie d'un écran à cristal liquide. La figure 12 représente de façon plus détaillée un point de croisement de l'écran et la figure 11 représente une vue en coupe aa de la figure 12 où l'on voit plus clairement la structure d'un transistor d'un pont de croisement. On se reportera donc plus spécialement dans la description qui va suivre aux figures 11 et 12 pour décrire un transistor de commande de l'écran mais pour une meilleure compréhension on pourra également se reporter à la figure 2 dont les mêmes références désignent les mêmes éléments.

Sur une face 10 d'un substrat sont disposés des électrodes de commande de lignes telles que LG, des grilles telles que GR et des portions d'électrodes de colonnes Col 1, Col 2. Selon l'exemple de réalisation représenté sur les figures, une grille GR est constituée par une portion d'électrode de ligne.

Les grilles GR et électrodes de lignes sont recouvertes d'une couche d'un matériau isolant tel que du Si₃N₄. Sur cette couche, audessus de chaque grille se trouve un élément en matériau semiconducteur 3 non dopé tel que du silicium amorphe.

Pour compléter le transistor de commande une source SO et un drain DR sont situés sur l'élément 3 de part et d'autre de la grille. Cette source et ce drain sont en semiconducteur dopé, tel que du silicium dopé n⁺, recouvert d'une couche métallique.

L'ensemble est recouvert d'une couche d'isolant de passivation 6 tel que du Si₃N₄ ou SiO₂.

Sur cette couche isolante 6 sont réalisés les éléments images PX ainsi que des écrans de lumière EC, les électrodes de commande de colonnes et des portions d'électrodes de lignes telles que lg 1.

Les écrans de lumière EC couvre chacun une surface supérieure à un espace drain-source de façon à abriter de la lumière le semiconducteur non dopé.

Enfin, des éléments de connexions complètent la réalisation c'est ainsi que :
- des éléments de connexion tels que CSP traversent la couche d'isolant de passivation 6 et connectent chacun une source SO à un élément image PX ;
- des éléments de connexion tels que CDC traversent la couche d'isolant de passivation 6 et connectent chacun un drain DR à une électrode de commande de colonne ;
- des éléments de connexion tels que CX3, CX4, CX5 traversent les deux couches d'isolant 2 et 6 et connectent, d'une part, les portions d'électrodes de lignes (lg 1) aux électrodes de commande de ligne LG (ce qui est le cas pour l'élément CX3), et d'autre part, les électrodes de colonnes CL aux portions d'électrodes de colonnes Col 1, Col 2 (ce qui est le cas pour les éléments CX4, CX5).

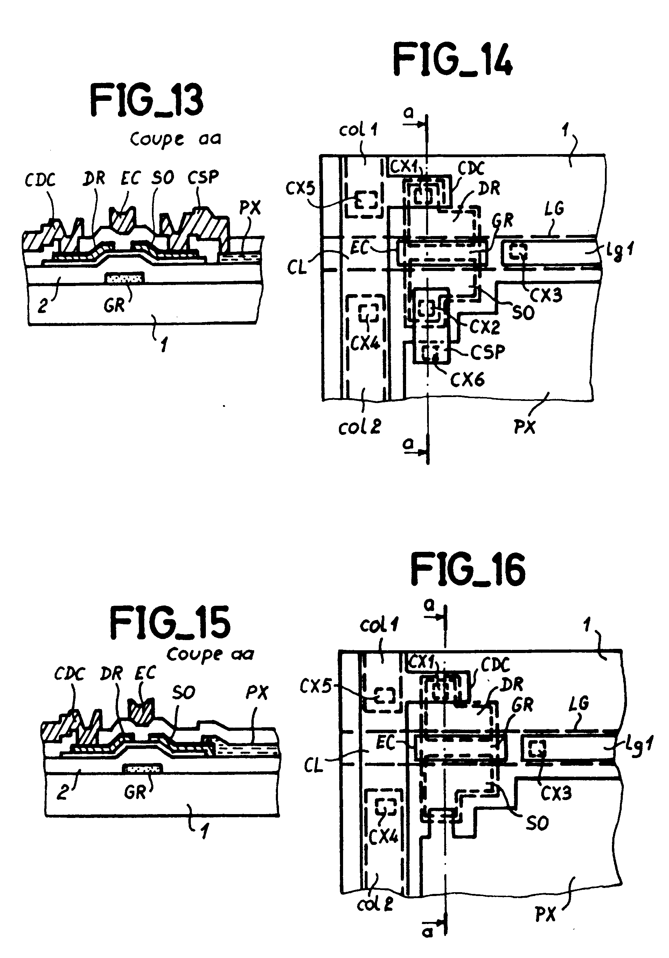

Selon une variante de réalisation de l'écran de l'invention, comme cela est représenté sur les figures 13 et 14, les éléments images PX sont situés entre les deux couches de matériau isolant 2 et 6. La couche isolante sert alors de capacité de stockage pour l'écran. De plus, ceci permet de diminuer le nombre de points faux parce que les électrodes de lignes et les électrodes de colonnes ne sont plus au même niveau que les éléments images.

Dans ce cas, chaque élément de connexion CSP, connectant une source SO à un élément image PX, traverse la couche isolante 6.

Selon une autre variante de réalisation représentée en figures 15 et 16 et dérivée de celle des figures 13 et 14, chaque élément image PX est directement connecté, par des connexions KC, à une source SO.

Selon une autre variante de réalisation, des éléments de connexion non représentés connectent l'écran de lumière à la grille situé en dessous. On obtient ainsi un transistor à double grille.

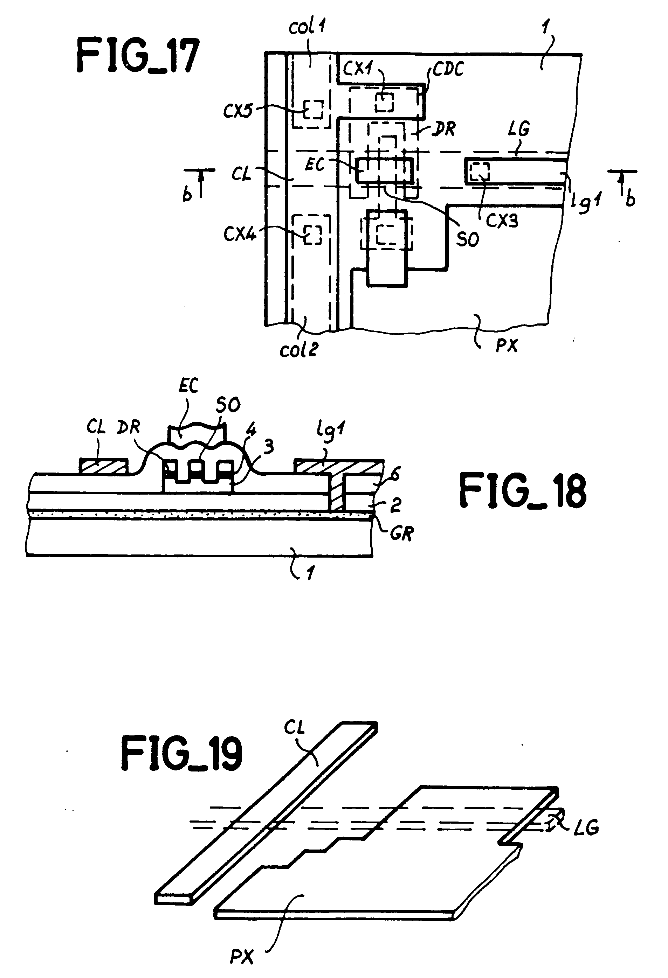

Une autre variante de réalisation selon l'invention comporte, comme cela est représenté en figure 17 et 18, au moins une indentation pour la source S0 de telle façon que celle-ci soit disposée transversalement par rapport à la grille GR, et au moins une autre indentation pour le drain DR, dirigée parallèlement à la source de telle façon que le drain soit également transversal par rapport à la grille. Une telle réalisation permet d'avoir un transistor géométriquement constant pour toutes les variations de positionnement des masques. Une double indentation de drain permet de gagner de la place et de s'affranchir des variations des largeurs des traits sur les capacités parasites du T.F.T.

Dans l'exemple de réalisation les figures 17 et 18, le drain DR comporte deux indentations encadrant la source S0.

Au dessus de la grille et chevauchant le drain et la source, l'écran de lumière protège de la lumière le transistor. Il est a noter que le transistor est entièrement abrité par la grille GR de la lumière venant à travers le substra 1.

Enfin, selon une autre variante représentée de façon simplifiée en figure 19, l'élément image PX possède au moins une indentation se prolongeant au dessus de l'électrode de ligne de façon à constituer avec l'isolant situé entre cette indentation et l'électrode de ligne, une capacité de stockage. Cette capacité de stockage permet d'améliorer le temps de maintien de l'affichage et d'améliorer les teintes de gris. De plus, en donnant à cette indentation de l'élément image une largeur maximale, cette indentation peut constituer un blindage pour le cristal liquide contre les effets de la tension de l'électrode de ligne.

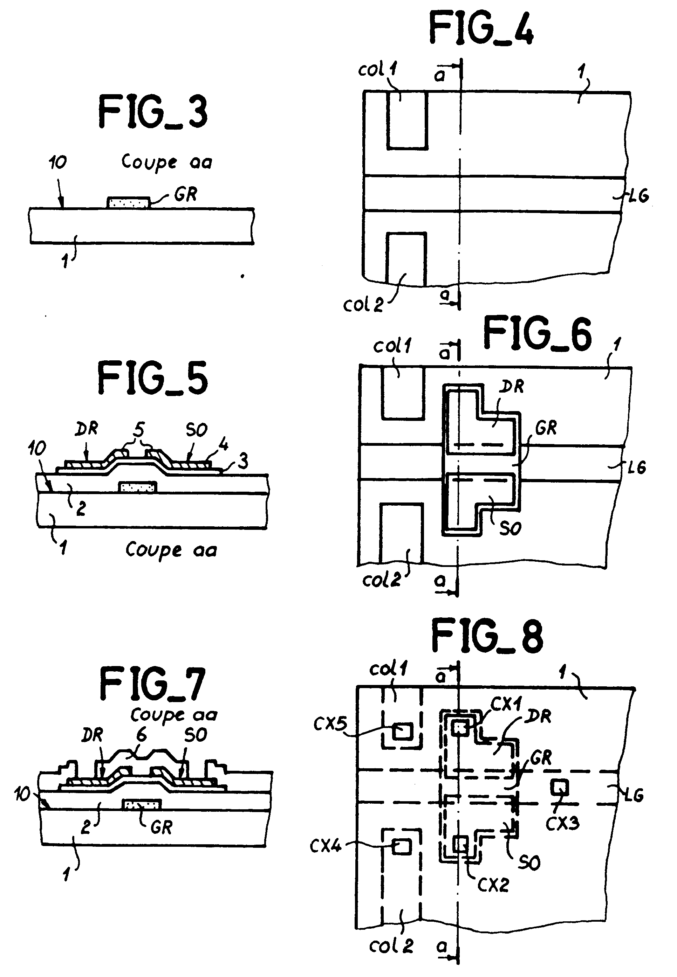

On va maintenant décrire un exemple de procédé de réalisation conforme à l'invention. Les figures 3 à 12 illustrent différentes étapes de ce procédé.

Au cours d'une première étape on réalise sur une face 10 d'un substrat 1, telle qu'une lame de verre, des électrodes en matériau conducteur de commande de lignes LG, des grilles GR connectées à ces électrodes et des portions d'électrodes de colonnes Col 1, Col 2 appelées renforts de colonnes. On obtient ainsi une configuration représentée en figures 3 et 4 dans lesquelles, à titre d'exemple, une grille GR est en réalité une partie d'une électrode de commande de ligne LG. Cette étape de réalisation est faite par dépôt d'une couche métallique mince sur un substrat vierge dans les meilleurs conditions de température et de nettoyage possibles pour obtenir un métal faiblement résistif et sans trous, puis par photolithographie par attaque des lignes, grilles des transistors, et renforts de colonnes. Ce métal, s'il est chimiquement résistant comme le chrome, peut être nettoyé violemment par acides.

Au cours d'une deuxième étape on réalise successivement une couche 3 d'un matériau semiconducteur amorphe, une couche 4 d'un matériau semiconducteur dopé n⁺ et éventuellement une couche 5 d'un matériau métallique. Par exemple, on dépose successivement dans la même machine un isolant de grille, par exemple Si₃N₄, un semiconducteur, par exemple du silicium amorphe non dopé, une couche pour contact ohmique, par exemple une couche de silicium amorphe dopé n⁺. Toutes ces couches seront, par exemple, réalisées par une méthode de décomposition thermique assistée plasma ou bien par sputtering. On dépose éventuellement un métal, tel que le chrome, en couche très mince. Ce métal sert par la suite à augmenter la sélectivité lors de l'attaque des isolants de grille et de passivation, ou bien à protéger le silicium amorphe sous cette couche.

Au cours d'une troisième étape, on grave le métal et le silicium dopé n⁺ en plots de contacts source SO et drain DR dans une deuxième opération de photolithographie. Une telle étape est facile à régler car on attaque du silicium en très grande surface, ce qui permet des détections de fin d'attaque très précises par voie sèche, le signal renvoyé étant très important. La couche de semiconducteur non dopé peut être très fine et il est connu qu'elle est alors beaucoup moins photoconductrice.

On grave le silicium non dopé dans une troisième opération de photolithographie qu'on peut rendre très précise vis-à-vis de l'isolant car on grave une couche très mince, très uniforme non dopée, et très étendue.

On obtient ainsi un composant tel que représenté en figures 5 et 6.

Au cours d'une quatrième étape, on dépose un isolant 6 de passivation inorganique tel que Si₃N₃ ou SiO₂ sur la structure précédente qui est facile à nettoyer par des bains acides, avec des marches très faibles à franchir pour l'isolant de passivation.

Au cours d'une cinquième étape, on grave cet isolant de passivation 6 et parfois l'isolant de grille 2 en une quatrième opération de photolithographie. On permettra ainsi la réalisation ultérieure des contacts nécessaires à la sortie des sources et drains des transistors, nécessaires aux sorties en bout de lignes et colonnes par le métal des lignes et colonnes, et éventuellement pour connecter l'écran de lumière à la grille.

Au cours d'une sixième étape, on réalise un dépôt d'une couche conductrice et éventuellement transparente par exemple de l'oxyde d'indium dopé à l'étain (dit ITO). Ce dépôt est gravé en une septième étape en point image PX, plots de contacts, éventuels doublement des lignes et colonnes ou capacité de stockage avec double isolant.

Au cours d'une huitième étape, on réalise un dépôt d'un métal. Celui-ci est gravé en une neuvième étape en colonnes, reprise de contacts sur source et drain, contacts source et point images, doublement des lignes, écran de lumière.

Selon une variante du procédé de réalisation on peut prévoir à ce stade de connecter l'écran de lumière EC à la grille GR pour réaliser un transistor à double grille.

Selon ce mode de réalisation, on peut corriger les défauts dus aux court-circuits. Comme l'intersection lignes et colonnes est doublée en isolants, et c'est un avantage certain, la plupart des court-circuits seront localisés sur le transistor. Il suffit donc de couper les arrivées sur ces transistors pour isoler ces défauts majeurs sans devoir couper la ligne ou la colonne (prix électronique). On connectera éventuellement aux deux extrémités les lignes et colonnes coupées. On notera que l'écran de lumière sur un isolant déposé sur marche peu importante est bien mieux isolé que dans la méthode classique à source drain et colonnes autoalignées.

L'isolation du cristal liquide, et des colonnes et lignes métalliques peut être fait sans inconvénient par un dépôt de polymère organique qu'on pou rra enlever par des solvants organiques, sur les contacts extérieurs, une fois la cellule scellée.

Une dixième étape de finition de l'écran peut être considérée comme classique. Elle comprend la réalisation de la contre lame, des filtres colorés éventuels, des couches d'ancrages sur les deux lames (polyimide frotté, évaporation de SiO, ...), du scellement des deux lames, du remplissage en cristal liquide, de l'enlèvement des polymères de passivation et éventuellement d'ancrage sur les contacts.

Selon une variante du procédé de réalisation de l'invention on prévoit de réaliser les éléments images PX entre les deux couches d'isolant 2 et 6. Pour cela, selon cette variante de procédé, la sixième et la septième étapes précédemment décrites sont réalisées avant la quatrième étape de dépôt de l'isolant de passivation 6. On obtient ainsi une structure telle que représentée en figures 13 et 14.

Selon une autre variante de procédé dérivée de celle qui précède et représentée en figures 15 et 16, la sixième et la septième étapes étant réalisées avant la quatrième étape, on prévoit lors de la septième étape de gravure des éléments images PX de graver également des éléments de connexion KC connectant directement une source SO à un élément image PX. De plus, selon cette variante on prévoit lors des deuxième et troisième étapes de réaliser tout d'abord l'élément en matériau semiconducteur amorphe 3, puis de réaliser ensuite la couche de matériau semiconducteur dopé 4 et la couche métallique 5, et de graver ensuite ces deux dernières couches.

Dans ces conditions, le matériau semiconducteur amorphe 3 n'est pas en contact avec l'élément image PX.

Enfin, selon une autre variante de réalisation, la sixième et la septième étapes peuvent être réalisées après la neuvième étape.

Le procédé de l'invention permet ainsi d'obtenir un écran dans lequel chaque point de croisement possède une double isolation et dans lequel chaque point image possède une capacité de stockage importante.

Il est bien évident que la description qui précède n'a été donnée qu'à titre d'exemple et que d'autres variantes peuvent être envisagées sans sortir du cadre de l'invention.

## Revendications

1. Ecran de visualisation électrooptique à transistors de commande comportant :
- une première et une deuxième lames parallèles (1, 1') enserrant un matériau électrooptique (CX) ;
- la première (1) lame étant munie sur sa face (10) en contact avec le matériau électrooptique (CX) (l'une matrice d'éléments image (PX11 à PX22) arrangés en lignes et colonnes, d'électrodes de commande de lignes (LG1, LG2) à raison d'une électrode associée à chaque ligne d'éléments image de ladite matrice et disposé parallèlement à chaque ligne (l'éléments image, et de transistors de commande (T11 à T22) à raison d'un transistor par élément image (PX11 à PX 22) couplant celui-ci à ladite électrode de commande de ligne ;
- la deuxième lame (1') étant munie sur sa face (10') en contact avec le matériau électrooptique (CX) d'au moins une électrode (F) ;
- chaque transistor comportant :
- une grille (GR) disposée sur la face (10) et associée à une électrode de commande de ligne (LG) ;
- une première couche (2) en matériau isolant recouvrant l'ensemble de la face (10), avec les électrodes de commande de la ligne (LG) et les grilles (GR) ;
- un élément en matériau semiconducteur amorphe (3) chevauchant la grille (GR) ;
- une source (SO) disposée sur cet élément en matériau semiconducteur amorphe (3) et s'étendant d'un bord de la grille vers un élément image ;
- un drain (DR) disposé sur ledit élément en matériau semiconducteur amorphe (3) et s'étendant d'un autre bord de la grille vers une électrode de colonne ;
- une deuxième couche en matériau isolant (6) recouvrant l'ensemble de l'écran ;
- un écran de lumière (EC) disposé au-dessus de la grille (GR) ;
caractérisé en ce qu'il comporte également :
- au moins un élément image (PX) situé soit entre la première couche en matériau isolant (2) et la deuxième couche en matériau isolant (6), soit sur la deuxième couche en matériau isolant (6) ;
- ainsi que les éléments suivants disposés sur la deuxième couche en matériau isolant (6) ;
- un premier élément de connexion (CSP, KC) connectant la source (SO) à l'élément image (PX) soit en traversant la deuxième couche d'isolant (6) soit par connexion directe ;
- au moins une électrode de commande de colonne (CL) ;
- un deuxième élément de connexion (CDC) traversant la deuxième couche d'isolant (6) et connectant le drain (DR) à ladite colonne.

2. Ecran selon la revendication 1, caractérisé en ce que l'écran de lumière (EC) est en matériau métallique.

3. Ecran selon la revendication 1, caractérisé en ce qu'il comporte sur la face (10) de la première lame (1) des portions de doublage d'électrodes de colonnes (Col 1, Col 2) interrompues à proximité de chaque transistor de commande et connectées, par des éléments de connexion (CX4, CX5) traversant la première et la deuxième couches d'isolant (2 et 6), à une électrode de commande de colonne (CL).

4. Ecran selon la revendication 1, caractérisé en ce qu'il comporte sur la deuxième couche de matériau isolant (6) des portions de doublage d'électrodes de lignes (LG1) interrompues à proximité de chaque transistor et connectées, par des éléments de connexion (CX3) traversant la première et la deuxième couches d'isolant (2 et 6), à une électrode de ligne (LG).

5. Ecran selon la revendication 1, caractérisé en ce que élément en matériau semiconducteur amorphe (3) est légèrement compensé en bore pour en diminuer la photoconductivité.

6. Ecran selon la revendication 1, caractérisé en ce que :
- l'élément en matériau semiconducteur amorphe (3) recouvre une partie de la grille (GR) de façon à être complètement protégé de la lumière arrivant du substrat :
- la source (SO) comporte une au moins indentation transversale par rapport à la grille (GR) et à l'élément en matériau semiconducteur (3) ;
- le drain (DR) comporte également au moins une indentation parallèle à l'indentation de la source (SO) ;
- l'écran de lumière (EC) est déposé au-dessus de la grille et de l'élément en matériau semiconducteur (3), chevauchant ainsi les indentations de la source et du drain.

7. Ecran selon la revendication 1, caractérisé en ce que le drain (DR) comporte au moins deux indentations encadrant une indentation de la source (SO).

8. Ecran selon la revendication 1, caractérisé en ce que l'élément image (PX) comporte une indentation se prolongeant au-dessus de l'électrode de ligne qui la commande.

9. Procédé de réalisation d'un écran à cristal liquide selon la revendication 1, comportant les étapes suivantes :
a) une première étape de réalisation sur une face (10) de ladite première lame d'électrodes de commande de lignes (LG), de grilles (GR) connectées à ces électrodes de commande de lignes (LG) et de portions d'électrodes de colonnes (Col 1, Col 2) ne coupant pas les électrodes de lignes (LG) ;
b) une deuxième étape de réalisations successives d'une première couche d'isolant (2), d'une couche d'un matériau semiconducteur amorphe (3), d'une couche d'un matériau semiconducteur dopé (4), et éventuellement d'une couche métallique ;
c) une troisième étape de deux gravures, dans la couche de matériau semiconducteur amorphe (3), d'éléments chevauchant chacune une grille (GR) et, dans la couche de matériau semiconducteur dopé et dans la couche métallique d'une source (SO) et d'un drain (DR) laissant un espace libre au-dessus de la grille et s'étendant, pour la source (SO) , vers l'emplacement d'un élément image et pour le drain (DR) vers l'emplacement d'une électrode de colonne ;
d) une quatrième étape de réalisation d'une deuxième couche d'isolant de passivation (6) ;
e) une cinquième étape de gravure de cavités (CX1, CX2) de reprises de contacts traversant la deuxième couche d'isolant (6) à l'emplacement des sources et drains et des cavités (CX3, CX4, CX5) de reprises de contacts traversant la première et la deuxième couche d'isolant (2, 6) à l'emplacement des électrodes de lignes et de colonnes ;
f) une sixième étape de dépôt d'une couche d'un matériau conducteur ;
g) une septième étape de gravure d'éléments image (PX) dans cette couche conductrice ;
h) une huitième étape de dépôt d'une couche métallique ;
i) une neuvième étape de gravure dans cette couche métallique :
- d'électrodes de commande de colonnes passant par les cavités de reprises de contacts (CX4, CX5) leur permettant d'être connectées à des portions d'électrodes de colonnes (Col 1, Col 2) ;
- de portions d'électrodes de lignes passant par les cavités de reprise de contacts (CX3) leur permettant (l'être connectées à des électrodes de commande de lignes (LG) ;
- d'éléments de connexion connectant d'une part une source (SO) à une électrode de colonne et d'autre part un drain à un élément image ;
- d'écrans de lumière (EC) protégeant de toute lumière incidente le matériau semiconducteur amorphe se trouvant au-dessus de la grille ;
j) une deuxième étape de finition d'un écran comportant les opérations suivantes :
- dépôt d'une couche d'ancrage ;
- mise en place de cales d'épaisseur ;
- réalisation d'une contre lame avec contre électrode transparente recouverte d'une couche d'ancrage ;
- mise en place d'un cristal liquide.

10. Procédé selon la revendication 9, caractérisé en ce que la deuxième étape est complétée par la réalisation d'une couche de métal (5) et en ce qu'au cours de la troisième étape cette couche est également gravée pour réaliser les contacts de source (SO) et de drain (DR).

11. Procédé selon la revendication 9, caractérisé en ce que la première étape comporte une phase de dépôt d'une couche métallique sur une face (10) d'un substrat (1) suivie d'une phase de gravure par photolithographie des électrodes de commande de lignes (LG), des grilles (GR) et des portions d'électrodes de colonnes (Col 1, Col 2).

12. Procédé selon la revendication 9, caractérisé en ce que l'isolant est du Si₃N₄.

13. Procédé selon la revendication 9, caractérisé en ce que le matériau semiconducteur est du silicium.

14. Procédé selon la revendication 9, caractérisé en ce que la deuxième étape est réalisée par une méthode de décomposition thermique assisté par plasma ou par sputtering.

15. Procédé selon la revendication 9, caractérisé en ce que la deuxième étape comporte la réalisation d'une couche métallique (5) sur la couche de matériau semiconducteur dopé (4).

16. Procédé selon la revendication 15, caractérisé en ce que la troisième étape comporte :
- une première phase de gravure de la couche métallique (5) et de la couche de matériau semiconducteur dopé (4) ;
- une deuxième phase de gravure de la couche de matériau semiconducteur amorphe (3).

17. Procédé selon la revendication 9, caractérisé en ce que la troisième, la cinquième et la septième étapes sont réalisées par photolithographie.

18. Procédé selon la revendication 9, caractérisé en ce que la sixième et septième étapes précèdent la cinquième étape.

19. Procédé selon la revendication 9, caractérisé en ce que la sixième et la septième étapes précèdent la quatrième étape.

20. Procédé selon la revendication 19, caractérisé en ce que la septième étape prévoit de graver des éléments de connexion (CSP) des éléments images aux sources et que la neuvième étape ne prévoit pas alors la réalisation des éléments de connexion des éléments images aux sources.

21. Procédé selon la revendication 9, caractérisé an ce que la sixième et la septième étapes sont réalisées après la neuvième étape.

## Claims

1. An electrooptical viewing screen having control transistors comprising:
- first and a second parallel sheets (1, 1') enclosing at electrooptical material (CX);
- the first one (1) being provided on its surface (10), which is in contact with the electrooptical material (CX), with a matrix of image elements (PX11 through PX22) arranged in lines and columns, with line control electrodes (LG1, LG2) so that one electrode is associated with each line of image elements of the said matrix and is arranged parallel to each line of image elements, and with control transistors (T11 through T22) so that there is one transistor for each image element (PX11 through PX 22) coupling the same with the said line control electrode;
- the second sheet (1') being provided, on its surface (10') in contact with the electrooptical material (CX), with at least one electrode (F);
- each transistor comprising:
- a gate (GR) arranged on the surface (10) and associated with a line control electrode (LG);
- a first layer (2) of an insulating material covering the totality of the surface (10) with the line control electrodes (LG) and the gates (GR);
- an element (3) of an amorphous semiconductor material straddling the gate (GR);
- a source (SO) arranged on the said element (3) of amorphous semiconductor material and extending from the edge of the gate towards an image element;
- a drain (DR) arranged on the said element (3) of amorphous semiconductor material and extending from one edge of the gate towards a column electrode;
- a second layer (6) of insulating material covering the totality of the screen;
- a light screen (EC) arranged over the gate (GR);
characterized in that it furthermore comprises:
- at least one image element (PX) arranged either between the first layer (2) of insulating material and the second layer (6) of insulating material of on the second layer (6) of insulating material;
- and furthermore the following elements arranged on the second layer (6) of insulating material;
- a first connection element (CSP, KC) connecting the source (SO) with the image element (PX) either through the second insulating layer (6) or by a direct connection,
- at least one column control electrode (CL);
- one second connection element (CDC) extending through the second insulating layer (6) and connecting the drain (DR) with the said column.

2. The screen as claimed in claim 1, characterized in that the light screen (EC) is made of a metallic material.

3. The screen as claimed in claim 1, characterized in that it comprises, on the surface (10) of the first sheet (1), column electrode duplicating portions (Col 1, Col 2) interrupted adjacent to each control transistor and connected, by means of connection elements (CX4, CX5) extending through the first and the second insulation layers (2 and 6), with a column control electrode (CL).

4. The screen as claimed in claim 1, characterized in that it comprises, on the second layer (6) of insulating material, line electrode duplicating portions (LG1) interrupted adjacent to each transistor and connected, by means of connection elements (CX3) extending through the first and the second insulation layers (2 and 6), with a line electrode (LG).

5. The screen as claimed in claim 1, characterized in that an element (3) of amorphous semiconductor material is slightly compensated with boron in order to diminish the photoconductivity thereof.

6. The screen as claimed in claim 1, characterized in that:
- the element (3) of amorphous semiconductor material covers a part of the gate (GR) in such a manner that it is completely shielded from light coming from the substrate,
- the source (SO) comprises at least one recess transverse in relation to the gate (GR) and to the element (3) of semiconductor material,
- the drain (DR) comprises as well at least one recess parallel to the recess of the source (SO),
- the light screen (EC) is arranged over the gate and the element (3) of semiconductor material, thus straddling the recesses of the source and the drain.

7. The screen as claimed in claim 1, characterized in that the drain (DR) comprises at least two recesses encompassing one recess of the source (SO).

8. The screen as claimed in claim 1, characterized in that the image element (PX) comprises a recess extending over the line electrode which controls it.

9. A process for the manufacture of a liquid crystal screen as claimed in claim 1 comprising the following steps:
a) a first step of producing, on a surface (10) of tile said first sheet, line control electrodes (LG), gates (GR) connected with the line control electrodes (LG) and portions of column electrodes (Col 1, Col 2) not intersecting the line electrode (LG);
b) a second step of successively producing a first insulation layer (2), a layer (3) of amorphous semiconductor material, a layer (4) of doped semiconductor material and under certain circumstances a metallic layer;
c) a third step of performing two etching operations, in the layer (3) of amorphous semiconductor material, giving elements each straddling a gate (GR) and, in the layer of doped semiconductor material of a source (SO) and a drain (DR) leaving free a space over the gate and extending, for the source (SO), towards the site of an image element and for the drain (DR) towards the site of a column electrode;
d) fourth step of producing a second passivation insulation layer (6);
e) a fifth step of etching cavities (CX1, CX2) for contacts extending through the second insulation layer (6) to the sites of the sources and of the drains and cavities (CX3, CX4, CX5) for contacts extending through the first and the second insulation layers (2, 6) to the site of the line and column electrodes;
f) a sixth step of depositing a layer of a semiconductor material;
g) a seventh step of etching image elements (PX) in the conducting layer;
h) an eighth step of depositing a metallic layer,
i) a ninth step of etching, in this metallic layer;
- column control electrodes extending through the contact making cavities (CX4, CX5) so that they may be connected with portions of the column electrodes (Col 1, Col 2);
- portions of line electrodes extending through the contact cavities (CX3) so that they may be connected with line control electrodes (LG);
- connection elements connecting on the one hand a source (SO) with a column electrode and on the other hand a drain with an image element;
- light screens (EC) shielding the amorphous semiconductor material, which is arranged above the gate, from all incident light;
j) a second step of completing a screen comprising the following operations:
- deposition of an anchoring layer;
- arrangement of shims for spacing;
- production of an opposing sheet with a transparent opposing electrode covered by an anchoring layer;
- placement of a liquid crystal.

10. The process as claimed in claim 9, characterized in that the second step is completed by the production of a layer (5) of metal and in that during the course of the third step said layer is as well etched in order to produce contacts for the source (SO) and the drain (DR).

11. The process as claimed in claim 9, characterized in that the first step comprises a phase with the deposition of a metallic layer on one surface (10) of a substrate (1) followed by a phase of etching using photolithography of the line control electrodes (LG), gates (DR) and portion of column electrodes (Col 1, Col 2).

12. The process as claimed in claim 9, characterized in that the insulation is Si₃N₄.

13. The process as claimed in claim 9, characterized in that the semiconductor material is silicon.

14. The process as claimed in claim 9, characterized in that the second step is performed by a thermal decomposition method aided by plasma or by sputtering.

15. The process as claimed in claim 9, characterized in that the second step comprises the production of a metallic layer (5) on the layer (4) of doped semiconductor material.

16. The process as claimed in claim 15, characterized in that the third step comprises:
- a first phase of etching the metallic layer (5) and of the layer (4) of doped semiconductor material;
- a second phase of etching the layer (3) of amorphous semiconductor material.

17. The process as claimed in claim 9, characterized in that the third, the fifth and the seventh steps are performed by photolithography.

18. The process as claimed in claim 9, characterized in that the sixth and the seventh steps precede the fifth step.

19. The process as claimed in claim 9, characterized in that the sixth and the seventh steps precede the fourth step.

20. The process as claimed in claim 19, characterized in that the seventh step includes etching elements (CSP) for the connection of the image elements with the sources and in that the ninth step does not include the production of elements for the connection of the image elements with the sources.

21. The process as claimed in claim 9, characterized in that sixth and the seventh steps are performed after the ninth step.

## Patentansprüche

1. Elektrooptischer Anzeigebildschirm mit Steuertransistoren, der aufweist:
- eine erste und eine zweite parallele Tafel (1, 1'), die ein elektrooptisches Material (CX) einspannen;
- wobei die erste Tafel (1) auf ihrer Fläche (10), die mit dem elektrooptischen Material (CX) in Kontakt steht, mit einer Matrix von Bildelementen (PX11 bis PX22) versehen ist, die in Zeilen und Spalten angeordnet sind, mit Zeilenansteuerelektroden (LG1, LG2) im Verhältnis von einer zugeordneten Elektrode für jede Zeile von Bildelementen der Matrix, die parallel zu jeder Zeile von Bildelementen angeordnet ist, und mit Steuertransistoren (T11 bis T22) im Verhältnis von einem Transistor pro Bildelement (PX11 bis PX22), der dieses an die Zeilenansteuerelektrode ankoppelt;
- wobei die zweite Tafel (1') an ihrer Fläche (10'), die mit dem elektrooptischen Material (CS) in Kontakt steht, mit wenigstens einer Elektrode (F) versehen ist;
- wobei jeder Transistor aufweist:
- ein Gate (GR), das auf der Fläche (10) angeordnet und einer Zeilenansteuerelektrode (LG) zugeordnet ist;
- eine erste Schicht (2) aus Isoliermaterial, die die gesamte Fläche (10) mit den Zeilenansteuerelektroden (LG) und den Gates (GR) überdeckt;
- ein Element aus amorphem Halbleitermaterial (3), das das Gate (GR) überlappt;
- einen Source-Anschluß (SO), der auf dem Element aus amorphem Halbleitermaterial (3) angeordnet ist und sich von einem Rand des Gates zu einem Bildelement erstreckt;
- einen Drain-Anschluß (DR), der auf dem Element aus amorphem Halbleitermaterial (3) angeordnet ist und sich von einem anderen Rand des Gates zu einer Spaltenelektrode erstreckt;
- eine zweite Schicht aus Isoliermaterial (6), die den gesamten Bildschirm überdeckt;
- einen Lichtschirm (EC), der über dem Gate (GR) angeordnet ist;
dadurch gekennzeichnet, daß er auch aufweist:
- wenigstens ein Bildelement (PX), das entweder zwischen der ersten Schicht aus Isoliermaterial (2) und der zweiten Schicht aus Isoliermaterial (6) oder auf der zweiten Schicht aus Isoliermaterial (6) liegt;
- sowie die folgenden Elemente, die auf der zweiten Schicht aus Isoliermaterial (6) angeordnet sind;
- ein erstes Verbindungselement (CSP, KG), das den Source-Anschluß (SO) mit dem Bildelement (PX) verbindet, indem es die zweite Isolierschicht (6) durchquert, oder durch eine direkte Verbindung;
- wenigstens eine Spaltenansteuerelektrode (CL);
- ein zweites Verbindungselement (CDC), das die zweite Isolierschicht (6) durchquert und den Drain-Anschluß (DR) mit der Spalte verbindet.

2. Bildschirm nach Anspruch 1, dadurch gekennzeichnet, daß der Lichtschirm (EC) aus einem Metallmaterial besteht.

3. Bildschirm nach Anspruch 1, dadurch gekennzeichnet, daß er auf der Fläche (10) der ersten Tafel (1) Verdoppelungsabschnitte von Spaltenelektroden (Col 1, Col 2) aufweist, die in der Nähe jedes Steuertransistors unterbrochen und mit einer Spaltenansteuerelektrode (CL) durch Verbindungselemente (CX4, CX5) verbunden sind, die die erste und die zweite Isolierschicht (2 und 6) durchqueren.

4. Bildschirm nach Anspruch 1, dadurch gekennzeichnet, daß er auf der zweiten Schicht aus Isoliermaterial (6) Verdoppelungsabschnitte von Zeilenelektroden (LG1) aufweist, die in der Nähe jedes Transistors unterbrochen und mit einer Zeilenelektrode (LG) durch Verbindungselemente (CX3) verbunden sind, die die erste und die zweite Isolierschicht (2 und 6) durchqueren.

5. Bildschirm nach Anspruch 1, dadurch gekennzeichnet, daß das Element aus amorphem Halbleitermaterial (3) gering mit Bor kompensiert ist, um seine Photoleitfähigkeit zu vermindern.

6. Bildschirm nach Anspruch 1, dadurch gekennzeichnet, daß
- das Element aus amorphem Halbleitermaterial (3) einen Teil des Gates (GR) so überdeckt, daß es vollständig gegen das vom Substrat kommende Licht geschützt ist;
- der Source-Anschluß (SO) wenigstens eine Querausbuchtung bezüglich des Gates (GR) und des Elements aus Halbleitermaterial (3) aufweist;
- der Drain-Anschluß (DR) ebenfalls wenigstens eine zu der Ausbuchtung des Source-Anschlusses (SO) parallele Ausbuchtung aufweist;
- der Lichtschirm (EC) über dem Gate und dem Element aus Halbleitermaterial (3) aufgebracht ist und so die Ausbuchtungen für den Source- und den Drain-Anschluß überlappt.

7. Bildschirm nach Anspruch 1, dadurch gekennzeichnet, daß der Drain-Anschluß (DR) wenigstens zwei Ausbuchtungen aufweist, die eine Ausbuchtung des Source-Anschlusses (SO) umgeben.

8. Bildschirm nach Anspruch 1, dadurch gekennzeichnet, daß das Bildelement (PX) eine Ausbuchtung aufweist, die sich über die Zeilenelektrode verlängert, die sie steuert.

9. Verfahren zum Herstellen eines Flüssigkristallbildschirms nach Anspruch 1 mit den folgenden Schritten:
a) einem ersten Schritt des Ausbildens von Zeilenansteuerelektroden (LG), von Gates (GR), die mit diesen Zeilenansteuerelektroden (LG) verbunden sind, sowie von Abschnitten von Spaltenelektroden (Col 1, Col 2), die die Zeilenelektroden (LG) nicht schneiden, auf einer Fläche (10) der ersten Tafel;
b) einem zweiten Schritt des nacheinanderfolgenden Ausbildens einer ersten Isolierschicht (2), einer Schicht aus einem amorphen Halbleitermaterial (3), einer Schicht aus einem dotierten Halbleitermaterial (4) und gegebenenfalls einer Metallschicht;
c) einem dritten Schritt aus zwei Ätzvorgängen zum Ausbilden von Elementen, in der Schicht aus dem amorphen Halbleitermaterial (3), die jeweils ein Gate (GR) überlappen, sowie in der Schicht aus dotiertem Halbleitermaterial und in der Metallschicht eines Sourceanschlusses (SO) und eines Drainanschlusses (DR), wobei über dem Gate ein freier Raum gelassen wird, der sich für den Source-Anschluß (SO) zu der Stelle eines Bildelements und für den Drain-Anschluß (DR) zu der Stelle einer Spaltenelektrode erstreckt;
d) einem vierten Schritt des Ausbildens einer zweiten Passivierungsisolierschicht (6);
e) einem fünften Schritt des Ätzens von Höhlungen (CX1, CX2) zum Anbringen von Kontakten, die die zweite Isolierschicht (6) an der Stelle der Source- und Drainanschlüsse durchqueren, sowie Höhlungen (CX3, CX4, CX5) zum Anbringen von Kontakten, die die erste und die zweite Isolierschicht (2, 6) an der Stelle der Zeilen- und Spaltenelektroden durchqueren;
f) einem sechsten Schritt des Aufbringens einer Schicht aus einem leitenden Material;
g) einem siebten Schritt des Ätzens von Bildelementen (PX) in dieser leitenden Schicht;
h) einem achten Schritt des Aufbringens einer Metallschicht;
i) einem neunten Schritt des Ätzens in der Metallschicht:
- von Spaltenansteuerelektroden, die durch die Höhlungen zum Anbringen von Kontakten (CX4, CX5) verlaufen, die deren Verbindung mit den Abschnitten von Spaltenelektroden (Col 1, Col 2) ermöglichen;
- von Zeilenelektrodenabschnitten, die durch die Höhlungen zum Anbringen von Kontakten (CX3) verlaufen, die deren Verbindung mit den Zeilenansteuerelektroden (LG) ermöglichen;
- von Verbindungselementen, die einerseits einen Source-Anschluß (SO) mit einer Spaltenelektrode und andererseits einen Drain-Anschluß mit einem Bildelement verbinden;
- von Lichtschirmen (EC), die das amorphe Halbleitermaterial, das sich über dem Gate befindet, gegen jedes einfallende Licht schützen;
j) einem zweiten Schritt zur Fertigstellung eines Bildschirms, der die folgenden Operationen beinhaltet:
- Aufbringen einer Verankerungsschicht;
- Anbringen von Abstandsstücken;
- Ausbildung einer Gegentafel mit einer transparenten Gegenelektrode, die von einer Verankerungsschicht bedeckt ist;
- Einbringen eines Flüssigkristalls.

10. Verfahren nach Anspruch 9, dadurch gekennzeichnet, daß der zweite Schritt durch die Ausbildung einer Metallschicht (5) vervollständigt wird, und daß diese Schicht im Laufe des dritten Schritts ebenfalls geätzt wird, um die Kontakte des Sourceanschlusses (SO) und des Drainanschlusses (DR) auszubilden.

11. Verfahren nach Anspruch 9, dadurch gekennzeichnet, daß der erste Schritt eine Phase des Aufbringens einer Metallschicht auf einer Fläche (10) eines Substrats (1) aufweist, gefolgt von einer Phase des Photolithographieätzens der Zeilenansteuerelektroden (LG), der Gates (GR) und der Spaltenelektrodenabschnitte (Col 1, Col 2).

12. Verfahren nach Anspruch 9, dadurch gekennzeichnet, daß der Isolierstoff Si₃N₄ ist.

13. Verfahren nach Anspruch 9, dadurch gekennzeichnet, daß das Halbleitermaterial Silizium ist.

14. Verfahren nach Anspruch 9, dadurch gekennzeichnet, daß der zweite Schritt durch ein plasma- oder sputterunterstütztes, thermisches Zersetzungsverfahren realisiert wird.

15. Verfahren nach Anspruch 9, dadurch gekennzeichnet, daß der zweite Schritt die Ausbildung einer Metallschicht (5) auf der Schicht aus dotiertem Halbleitermaterial (4) enthält.

16. Verfahren nach Anspruch 15, dadurch gekennzeichnet, daß der dritte Schritt aufweist:
- eine erste Phase des Ätzens der Metallschicht (5) und der dotierten Halbleiterschicht (4);
- eine zweite Phase des Ätzens der Schicht aus amorphem Halbleitermaterial (3).

17. Verfahren nach Anspruch 9, dadurch gekennzeichnet, daß der dritte, der fünfte und der siebte Schritt durch Photolithographie realisiert werden.

18. Verfahren nach Anspruch 9, dadurch gekennzeichnet, daß der sechste und der siebte Schritt dem fünften vorausgehen.

19. Verfahren nach Anspruch 9, dadurch gekennzeichnet, daß der sechste und der siebte Schritt dem vierten vorausgehen.

20. Verfahren nach Anspruch 19, dadurch gekennzeichnet, daß der siebte Schritt vorsieht, daß Elemente (CSP) zur Verbindung der Bildelemente mit den Source-Anschlüssen geätzt werden, und daß der neunte Schritt dann nicht die Ausbildung der Verbindungselemente von den Bildelementen zu den Source-Anschlüssen vorsieht.

21. Verfahren nach Anspruch 9, dadurch gekennzeichnet, daß der sechste und der siebte Schritt nach dem neunten Schritt durchgeführt werden.
